# EUROPEAN PATENT SPECIFICATION

(11) **EP 1 176 723 B1**
(45) Date of publication and mention of the grant of the patent: **08.10.2003**
(21) Application number: 01117740.9
(22) Date of filing: 30.07.2001
(51) Int. Cl.: H03K 19/0185, H03K 19/003

(54) **Driver circuit for the delivery of an adjustable output signal current**
Treiberschaltung mit einstellbarem Ausgangsstrom
Circuit d'attaque à courant de sortie variable

(30) Priority: 28.07.2000 DE 10036863
(43) Date of publication of application: 30.01.2002
(73) Proprietor: TEXAS INSTRUMENTS DEUTSCHLAND GMBH, 85356 Freising (DE)
(72) Inventor: Rennig, Fred S., 85354 Freising (DE); Bakker, Peter, 81541 München (DE); Merk, Dieter, 85354 Freising (DE)
(74) Representative: Degwert, Hartmut, Dipl.-Phys.

(56) References cited:
- EP-A- 0 317 758
- DE-A- 4 200 680
- US-A- 5 191 234
- US-A- 5 334 891
- US-A- 5 534 801
- US-A- 5 602 494
- US-A- 5 703 496

## Description

The invention relates to a driver circuit for the delivery of an adjustable output signal current at a driver output, as defined in the precharacterizing portion of claim 1.
To generate the signals fed to the data inputs of processors, driver circuits are normally used that ensure that these control signals conform to the mandatory criteria such as voltage level and pulse edge gradient as determined by the processor specification. The voltage level is determined by the generation of a specific output current by the driver circuit which causes a voltage drop at a resistor connected to the driver output that corresponds to the desired voltagelevel of the processor control signal. Since different processors also require control signals of different voltage levels, it is desirable that the driver circuit should be capable of delivering differing output currents for them to produce the desired voltage level at the resistor connected to the output . In order to comply with this requirement, several partial driver circuits are provided in a known driver circuit, each of which can be set into either an active or a passive state by means of a control signal. Depending on the number of partial driver circuits being in their active state, either a greater or a smaller current is delivered at the driver output so that, with an appropriate selection of the resistor connected to the output, the desired output voltage for the corresponding processor can be generated in each case.

When a data signal is to be delivered to a processor by means of such a driver circuit, the rising slope of the data signals supplied to the driver input causes at any time such a number of partial driver circuits simultaneously to deliver a current to the driver output as is required for the generation of the desired control voltage for the processor. This simultaneous switching of the partial driver circuits, active at any time, however leads to a steep rising slope of the control signal generated which, in its turn, gives rise to the generation of parasitic signals in the circuit configuration containing the driver circuit and the processor. These parasitic signals always occur at the change of the input signal from a high to a low level and vice versa and become stronger as the number of driver circuits in an active state increases, that is those contributing to the generation of the output current.

In this context, reference is made to US-A-5 703 496, which discloses a driver circuit of the type indicated above. The driver circuit comprises pairs of flash-programmable elements and output transistors connected in parallel. In addition, that document shows another arrangement comprising an output driver which is configured to forward output signals to all of its output transistors and with flash cells that are programmed to adjust a time delay occurring prior to reception by the output transistors. This is achieved by setting the threshold voltage for the flash elements to differing values. The flash cells may be programmed to provide sequentially increasing time delays. Hence, the corresponding output transistors are activated sequentially resulting in a reduction in the increase of current drawn as a function of time, thereby reducing the total amount of voltage noise.

Reference is further made to US-A-5 334 891, which discloses a variable delay circuit for producing a delay which varies as a hyperbolic function of the current intensity. The delay circuit comprises a plurality of differential amplifiers. Each differential amplifier has a direct input for the direct input signal and a complementary input for the complementary input signal, as well as a direct output for the delivery of an output signal current corresponding to a direct input signal, and a complementary output for the delivery of the complementary output current. Furthermore, each differential amplifier comprises a current branch from a current source made of a bipolar transistor with its base connected to a reference potential and a resistive load to the direct output and a current branch from this current source to the complementary output, where each current branch comprises a switching device of which one is controlled by the direct input signal and the other by the complementary input signal.

In accordance with the invention, a driver circuit as defined in claim 1 is provided.

An advantage of the inventive driver circuit is that it ensures that a reference current flows at any time in at least one of the two current paths when the switching processes take place in the partial driver circuits, so that the loading of the supply source remains steady at all times and therefore no parasitic signals can come in over the supply line.

The application of the procedure according to the invention ensures that, independently from the value of the output signal current to be set, that is from the number of active partial driver circuits at any time, the same time span always elapses from the beginning of the current rise to the point of reaching its maximum value in each case. This makes it possible that by the use of the driver circuit according to the invention, even when using different processors for which the different output signal currents must be generated, the respective processor specifications regarding the processor input signal can be complied with.

The invention shall now be explained in exemplified form, with reference to the drawing, where
Figure 1 shows a schematic diagram of the driver circuit according to the invention,
Figure 2 is a table to explain the operation of the driver circuit of Figure 1, and
Figure 3 represents the circuit of one of the partial driver circuits of Figure 1.

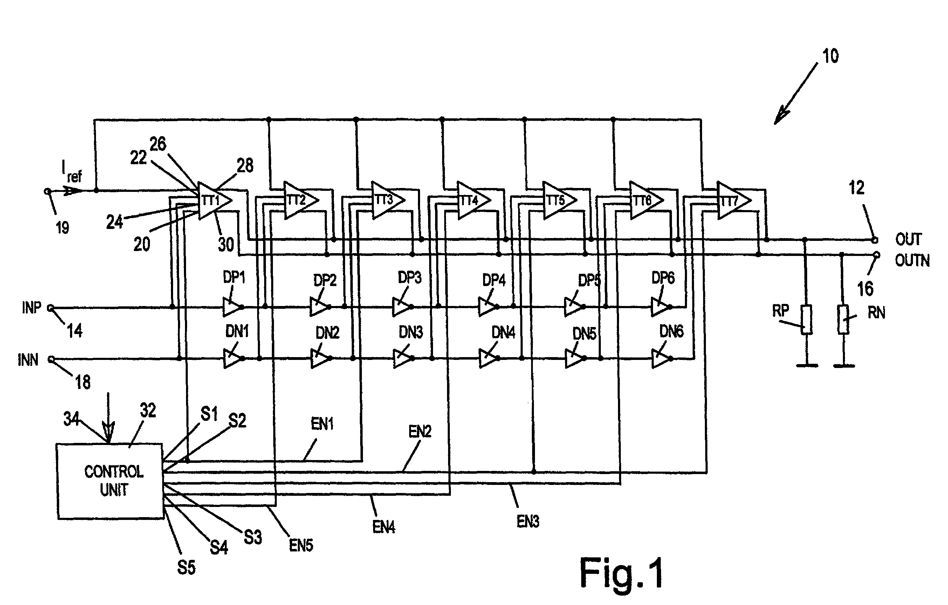

The driver circuit 10 of Figure 1 serves to generate an adjustable current across a resistor RP, which at this resistor RP produces a voltage drop available at an output 12, which represents the output signal OUT. This output signal OUT is then to represent the data value of the input signal INP fed to an input 14. Since the driver circuit is configured as a differential circuit, it also generates a current, flowing through a resistor RN, which at an output 16 produces a voltage drop which represents the complementary output signal OUTN, which in its turn represents the data value of a complementary input signal INN delivered to the input 18.

As can be seen, the driver circuit 10 has an input 19 which is provided with a reference current Iref. Seven partial driver circuits TT1 to TT7 have been provided, each of which having an activation input 20 and which, by means of a setting signal supplied to this activation input 20 can be put into either an active or inactive state. The partial driver circuits TT1 to TT7 furthermore each have a direct input 22 for the direct input signal INP, applied to the input 14, as well as a complementary input 24 for the complementary input signal INN applied to the input 18. The reference current Iref is supplied to each of the partial driver circuits TT1 to TT7 at an input 26. Furthermore, each of the partial driver circuits TT1 to TT7 has a direct output 28 for the purpose of delivering the current for the generation of the output signal OUT, as well as a complementary output 30 for the purpose of delivering the current for the generation of the complementary output signal OUTN. For reasons of clarity of the drawing, the individual inputs and outputs of the partial driver circuits TT1 to TT7 of only the first partial driver circuit TT1 have been annotated. The direct input signal INP applied to the input 14 is applied without delay to the direct input 22 of the first driver circuit TT1, and to the following partial driver circuits TT2 to TT7 via a delay element DP1 to DP6 each. In the same manner is the complementary input signal INN, present at the input 18, then applied without delay to the complementary input 24 of the first partial driver circuit TT1, and to the complementary inputs of the following driver circuits TT2 to TT7 via the delay elements DN1 to DN6.

Dependent on a control signal applied to its input 34, a control unit 32 can produce setting signals EN1 - EN5 at its outputs S1 to S5, with which the partial driver circuits TT1 to TT7 can be put into either the active or the inactive state, for the purpose of obtaining the desired current values across the resistors RP and RN, in that they either contribute or not contribute to the generation of the desired output signal current.

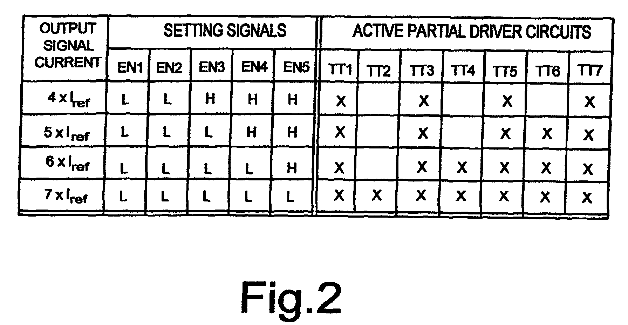

In the example here described it is assumed that the current flowing through the resistors RP and RN shall be set to values that correspond to four times, five times, six times or seven times the value of the reference current Iref. Since each of the partial driver circuits TT1 to TT7 contributes with its current share Iref to the totality of the output current, it follows that four of the partial driver circuits must be active to produce four times the value. The table of figure 2 indicates how this setting of the output signal current is achieved by using a different number of active partial driver circuits.

If, for example, the output signal current is to have four times the value of the reference current Iref, then the setting signals EN1 and EN2 are at the low signal value L and the setting signals EN3, EN4 and EN5 are each at the high signal value H. As is apparent from the wiring configuration shown in figure 1, these signals are used to put the partial driver circuits TT1, TT3, TT5 and TT7 into the active state, which is also apparent in the right-hand section of the table of figure 2 from the X-marks at the corresponding partial driver circuits. The reasons as to why the partial driver circuits, in order to obtain the desired output signal currents, have to be put into their active state in the manner shown in figure 2 will be explained in the following in greater detail.

If, with partial driver circuits TT1, TT3, TT5 and TT7 active, as in the assumed case, the direct input signal INP at input 14 and the data value "L" change to the data value "H", the result will be that the partial driver circuit TT1 at its direct output 28 delivers the reference current Iref virtually without delay. With a delay span of Δt of the individual delay elements DP1 to DP6, the partial driver circuit TT3 also delivers the output current Iref to its complementary output 30, after a delay of 2xΔt. After a further delay of 2xΔt, the partial driver circuit TT5, too, delivers the reference current Iref to its complementary output 30 until, finally, the direct input signal INP is received by the partial driver circuit TT7, delayed by a further 2xΔt, to deliver the reference current Iref at its complementary output 30. The current flow through the resistor RP is therefore increasing to four times the value of the reference current Iref, which then gives rise to the voltage drop appearing at the output 12 as the output signal OUT. This voltage value can then be used to drive the processor which is controlled by the driver circuit 10.

In the case described, the complementary input signal INN at input 18 changes its data value from "H" to the value "L", which has the result that, after the corresponding delays by the delay elements DN1 to DN6, the current flowing through the resistor RN decreases in four steps from four times the value of the reference current Iref to zero. In the same way as the current through the resistor RP increases, the time span in which the current through the resistor RN decreases then amounts to the total of 6xΔt.

The switching processes of the input signals INP and INN from the high data value to the low one, and vice versa, therefore do not cause large sudden current changes, but the current changes take place in steps after the corresponding delay times introduced by the delay elements DP1 to DP6 or DN1 to DN6, respectively, and therefore leading to relatively slow switching slopes which do not give rise to any large parasitic current spikes. As a result of the slow rise and fall of the current, there will be no high-frequency parasitic disturbances on the one hand, and the small current changes associated with each switching process do not cause any sudden changes in the loading of the supply source, so that even in this way no parasitic disturbances can occur overall in the circuit, of which the driver circuit 10 only represents one component.

If the driver circuit 10 is to control a processor requiring a higher control voltage, a larger current must be produced across the resistors RP and RN. If, for example, six times the value of the reference current Iref is to be produced, this is achieved in that the control unit 32 is fed a corresponding input signal to its control input 34, so that setting signals of the value "L" become available at its outputs S1 to S4, and a setting signal of the value "H" at the output S5. The result of this is that the partial driver circuits TT1, TT3, TT4, TT5, TT6 and TT7 are put into their active state and thereby contribute to the generation of the output signal current. Since even in this case where the partial driver circuit T1, which receives the input signals from the inputs 14 and 18 without delay, as well as the partial driver circuit TT7, which receives these input signals with the maximum possible delay, the same time span elapses for the change of the current from its minimum to its maximum value or from its maximum to its minimum value when the corresponding switching processes of the input signals take place.

Since the partial driver circuit TT1 and the partial driver circuit TT7 are in their active state for all settable current values, the same time span always results for the current changes in the resistors RP and RN at the corresponding switching processes of the input signals INP and INN. Because of this, the mandatory specifications for the processors to be controlled, concerning the rise and fall of the control signal slopes, can be positively adhered to, since the duration of the slopes is independent of the output signal current generated in a given case.

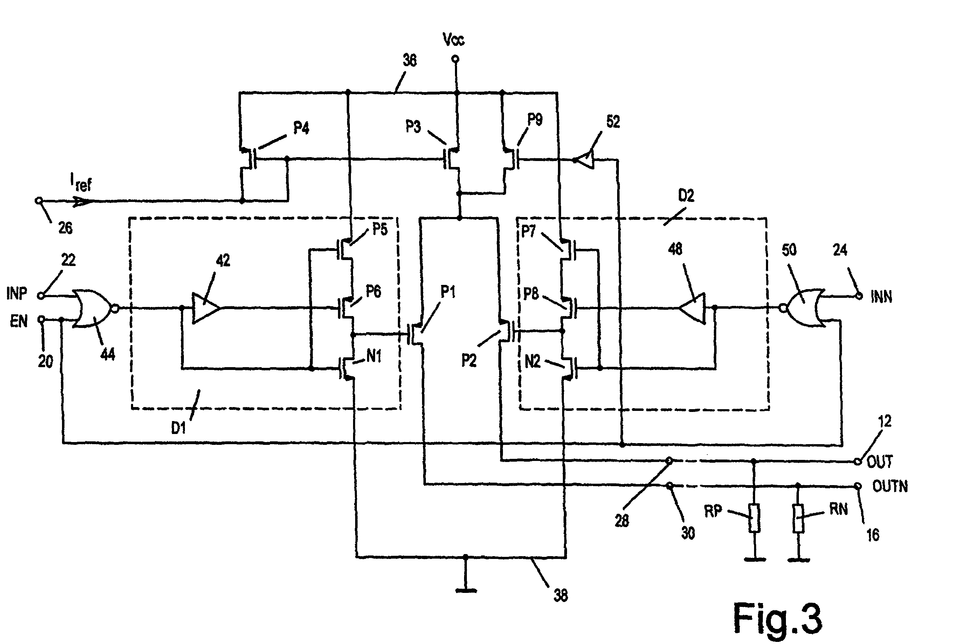

Figure 3 shows the circuit diagram of a partial driver circuit of the type used in the driver circuit of figure 1. The partial driver circuit comprises two current branches, connected in parallel to each other, each incorporating a p-channel field-effect transistor P1 and P2, whereby the drain terminal of the field-effect transistor P1 forms the direct output 30, which is connected to the resistor RN and the output 16, whilst the drain terminal of the field-effect transistor P2 forms the direct output 28, which is connected to the resistor RP and the output 12. The two resistors RP and RN serve all partial driver circuits TT1 to TT7 in common.

The source terminals of the field-effect transistors P1 and P2 are connected to each other, as well as to the drain terminal of a p-channel field-effect transistor P3, the source terminal of which is connected to the supply line Vcc. This field-effect transistor P3 and a further p-channel field-effect transistor P4, together form a current mirror circuit which ensures that the reference current Iref, applied to the input 20, flows through the source-drain path of the field-effect transistor P3. The field-effect transistor P4 is in common for all partial driver circuits TT1 to TT7. This current mirror circuit therefore ensures that the reference current Iref is mirrored into the source-drain path of the corresponding field-effect transistor P3 in every partial driver circuit.

The field effect transistors P1 and P2 in each case receive the direct input signal INP and the complementary input signal INN, respectively, via either delay circuit D1 or D2, the function of which will be explained in more detail further on. The delay circuit D1 comprises three field-effect transistors, connected in series, that is two p-channel field-effect transistors P5 and P6, as well as an n-channel field-effect transistor N1, connected between the supply line 36 and the ground rail 38. The gate terminals of the field-effect transistors P5 and N1 are connected to each other, and the gate terminal of the field-effect transistor P6 is connected to the output of a delay element 42. The delay element 42 of the delay circuit D1 receives the direct input signal INP via a NOR gate 44, whose first input is the direct input 22 of the partial driver circuit, whilst its second input is the input 20 for the setting signal.

The delay circuit D2 also contains three field-effect transistors connected in series, that is one p-channel field-effect transistor P7 and a p-channel field-effect transistor P8, as well as an n-channel field-effect transistor N2, connected between the supply line 36 and the ground rail 38. The gate terminals of the field-effect transistors P7 and N2 are connected to each other, and the gate terminal of the field-effect transistor P8 is connected to the output of a delay element 48. The delay element 48 receives the complementary input signal INN via a NOR gate 50, whose first input is the complementary input 24 of the partial driver circuit, whilst the second input is connected to the input 20 for the setting signal.

The setting signal from input 20 is also applied via a negator 52 to the gate terminal of a p-channel field-effect transistor P9, which is connected in parallel to the field-effect transistor P3.

The operation of the partial driver circuit of figure 3 is as follows:

It shall be assumed in the first instance that the partial driver circuit is in its active state, which is achieved by applying a setting signal of signal value "L" to the input 20, that is, a signal at a low voltage level. This has as a result that the output signal of both the NOR gates 44 and 50 assume, in each case, the complementary value of the signals INP and INN, respectively, as applied to the inputs 22 and 24.

It shall furthermore be assumed that a static condition prevails, whereby the direct input signal INP at the direct input 22 is at the signal value "H", that is a high voltage level, whilst the complementary signal INN at the complementary input is at the low signal value "L", that is a low voltage level. The NOR gate 44 therefore outputs a signal at a low voltage level which is also present at the inter-connected gate terminals of the field-effect transistors N1 and P5. The field-effect transistor N1 is thereby put into its off-state, whilst the field-effect transistor P5 is in its on-state. Under static conditions, the signal with a low voltage value is also present at the gate terminal of the field-effect transistor P6, so that this field-effect transistor P6 will also be in its conductive state. The consequence of this is that a high voltage is present at the gate terminal of the field-effect transistor P1, which puts this field-effect transistor into the off-state. Therefore the current Iref generated in the transistor P3 by way of the mirroring effect mentioned cannot flow through this field-effect transistor, so that as a result no current can flow either through the resistor RN to ground. The output signal OUTN at a low signal level is therefore present at the output 16, that is a signal complementary to the assumed input signal INP. The complementary input signal INN present at the complementary input 24 puts the field-effect transistors P7 and P8 into their off-state by way of the NOR gate 50, whilst the field-effect transistor N2 goes into the on-state. The consequence of this is that a signal with a low voltage value is present at the gate terminal of the field-effect transistor P2, which puts this field-effect transistor into the on-state. The reference current Iref, generated through mirroring in the field-effect transistor P3, therefore flows through this field-effect transistor P2 to ground, by way of the resistor RP. This current results in a voltage drop, which becomes available at the direct output 12 as output signal OUT. The signal value at the output 12, in this static condition, therefore corresponds to the signal value "H" of the direct input signal INP, whilst the signal value of the output signal OUTN corresponds to the signal value "L" of the complementary input signal INN.

Since, as can easily be seen, the circuit of figure 3 is of a symmetrical configuration, the same situation obtains in the other static condition, when the direct input signal INP is at the low signal level "L", and the complementary input signal INN at the high signal level "H". In this case, the field-effect transistor P1 is in its on-state, whilst the field-effect transistor P2 is in its off-state, therefore producing a voltage drop at the resistor RN which represents the output signal OUTN, whilst no current flows through the resistor RP, and the output signal OUT therefore has a low signal value, corresponding to the signal value of the direct input signal INP.

The case will now be considered where the direct input signal INP has the low signal value "L" and switches over to the high signal value "H". Accordingly, a switch-over of the complementary input signal from the high signal value "H" to the low signal value "L" takes place at the complementary input 24. As soon as the high signal value "H" is present at the direct input 22, a signal with the low signal value "L" becomes available at the output of the NOR gate 44. This signal reaches the gate terminals of the field-effect transistors N1 and P5 without being delayed. By this, the field-effect transistor N1 will be put into the off-state, and the field-effect transistor P5 changes into the on-state. This has no influence on the conducting field-effect transistor P1 as long the field-effect transistor P6 still remains in its off-state. Only when, after the delay produced by the delay element 42, the signal with the low value "L" also reaches the gate terminal of the field-effect transistor P6, this field-effect transistor will also change into the on-state, so that a signal corresponding to the supply voltage Vcc reaches the gate terminal of the field-effect transistor P1, which puts this field-effect transistor into its off-state. Here it should be noted that the change into the off-state of this transistor P1 takes place after a delay caused by the delay element 42. The signal with the high signal value "H" at the output OUTN therefore still remains present for the duration of this delay, although the direct input signal INP has already assumed the other state.

A switch-over of the complementary input signal from the signal value "H" to the signal value "L" takes place on the side of the complementary input 24, with the result that a signal with the high signal value "H" appears at the output of the NOR gate 50. This signal reaches the interconnected gate terminals of the field-effect transistors N2 and P7 without being delayed, whereby the field-effect transistor N2 is put into its on-state, whilst the field-effect transistor P7 changes into the off-state. These switch-over processes of the field-effect transistors N2 and P7 take place directly with the switching-over of the complementary input signal INN, with the result that the field-effect transistor P2 changes into the on-state without being subject to delay, so that accordingly also the direct output signal OUT at the output 12 assumes the high signal value "H" without being subjected to any delay. After a delay by the delay element 48, the signal with the high signal value also reaches the gate terminal of the field-effect transistor P8 and puts it into the off-state. This has no effect, since the field-effect transistor P7 in this circuit branch has already been put into its off-state.

The mode of operation described shows that the switch-over of the field-effect transistor P1 from the on-state to the off-state and the switch-over of the field-effect transistor P2 from the off-state to the on-state overlap by the delay times of the delay elements 42 and 48, respectively. The consequence of this is that at no point in time both the transistors can be in their off-state simultaneously. Without the provision of the delay elements 42 and 48, the condition is possible that, because of differing, tolerance-related, signal transit times within the circuit, both the field-effect transistors P1 and P2 can be in the off-state for a short duration, which would lead to a fluctuation in the loading of the supply source for the supply voltage Vcc. Such a load fluctuation can show up as a parasitic influence in an electronic circuit in which the driver circuit here described is used. The overlapping so produced ensures that the current Iref flows at least through one of the two transistors P1 or P2 at any time, so that the loading conditions of the supply voltage source always remain the same.

Because of the symmetrical configuration of the partial driver circuit of figure 3, switching over of the direct input signal INP from the low signal value "L" to the high signal value "H" and the corresponding switch-over of the complementary input signal INN from the high signal value "H" to the low signal value "L" will result in the corresponding change-over of the associated field-effect transistors from the on-state to the off-state and vice-versa, which also ensures that at no point in time both the two field-effect transistors P1 and P2 are in their off-states simultaneously since, as in the case example previously described, overlapping of the condition changes takes place in such a way that at least one of the two transistors is in its on-state at any given time.

By means of the setting signal EN at the input 20, the driver circuit of figure 3 can be put into the inactive state. When this setting signal EN has the high signal value "H", a signal with the low value "L" is present at each of the outputs of the two NOR gates 44 and 50, with the consequence that the two field-effect transistors P1 and P2 are in their off-state and that no current which could produce a voltage drop at any of the outputs 12 or 16 can flow through either of the resistors RP and RN. In this connection it should be noted that the switch-over of the partial driver circuits from the active to the inactive state takes place only once, when the value of the output signal current to be set by the driver circuit is established by the signal at the input 34 of the control unit 32. This is why this simultaneous blocking of the transistors P1 and P2 does not cause the disturbances which would be produced by the periodic switch-over of the input signals INP and INN from one signal value to the other, if the overlapping sequence of the conducting time spans of the field-effect transistors P1 and P2 had not been provided for.

## Claims

1. Driver circuit for the delivery of an adjustable output signal current at a driver output, whereby the output signal current in each case corresponds to one or the other binary data value of an input signal, with n partial driver circuits, connected in parallel both at their inputs and at their outputs, which for the purpose of setting the output signal current can be set into either an active or an inactive state by means of a setting signal, and which in their active state in each case deliver at their outputs a partial signal current corresponding to a constant reference current, depending on the data value of the input value, whereby the sum of the partial signal currents corresponds to the set output signal current, **characterized in that**
the input signal is applied to a first partial driver circuit (TT1) directly and to the second up to the nth partial driver circuits (TT2-TT7) delayed via 1, 2, ... or, respectively, n-1 delay elements (DP1-DP6, DN1-DN6) with a delay of 1xΔt, 2xΔt ... to (n-1)xΔt, respectively,
the partial driver circuits (TT1-TT7) are differential driver circuits having a direct input (22) for the direct input signal (INP) and a complementary input (24) for the complementary input signal (INN), as well as a direct output (12) for the delivery of an output signal current corresponding to a direct input signal (INP), and a complementary output (16) for the delivery of the complementary output current, and that both the direct input signal (INP) as well as the complementary input signal (INN) are applied to the inputs (22, 24) of the partial driver circuits (TT1-TT7) via delay elements (DP1-DP6, DN1-DN6),
each partial driver circuit (TT1-TT7) comprises a current branch (P3, P2) from a current source delivering the reference current to the direct output (12), and a current branch (P3, P1) from this current source to the complementary output (16), where each current branch comprises a switching device (P1, P2), of which one is controlled by the direct input signal (INP) and the other by the complementary input signal (INN) in such away that at least one of the two switching devices (P1, P2) will be in its on-state at any given time, and
the switching devices (P1, P2) are constituted by MOS field-effect transistors, where each of the partial driver circuits (TT1-TT7) comprises a first delay circuit (D1) which generates a voltage for the control of the MOS field-effect transistor assigned to the input (22) for the direct input signal (INP),and a second delay circuit (D2) which generates a voltage for the control of the MOS field-effect transistor assigned to the input (24) for the complementary input signal (INN), whereby these delay circuits (D1, D2), as a result of a change of the data value of the input signal, deliver the voltage generated by them for the switch-over of the MOS field-effect transistors controlled by them from the off-state to the on-state to these MOS field-effect transistors without being subjected to any delay, and the voltage generated by them for the switch-over of the MOS field-effect transistors from the on-state to the off-state is applied to these MOS field-effect transistors after a delay.

2. Procedure for the generation of an adjustable output signal current by using a circuit configuration according to claim 1 where, for the purpose of the delivery of a minimal output signal current of double the value of the reference current (Iref) by the setting signal, the partial driver circuit (TT1), receiving the setting signal directly, and the partial driver circuit (TT7), receiving the setting signal with a delay of (n-1)xΔt, are put into their active state, and where for the purpose of delivering higher output signal currents further partial driver circuits (TT2-TT6) are placed into their active state by the setting signal, to which the setting signal is applied after different delay times of between Δt and (n-1)xΔt.

## Patentansprüche

1. Treiberschaltung zum Bereitstellen eines anpassbaren Ausgangsstroms an einem Treiberausgang, wobei der Ausgangsstrom in jedem Fall dem einem oder dem anderen binären Datenwert eines Eingangssignals entspricht, mit n Teil-Treiberschaltkreisen, die sowohl mit ihren Eingängen als auch mit ihren Ausgängen parallel geschaltet sind, die zum Einstellen des Ausgangsstroms entweder in einen aktiven oder in einen inaktiven Zustand mit Hilfe eines Setzsignals versetzt werden können und die in ihrem aktiven Zustand in jedem Fall an ihren Ausgängen einen Teilstrom bereitstellen, der einem konstanten Referenzstrom entspricht und von dem Datenwert des Eingangswerts abhängt,
wobei die Summe der Teilströme dem eingestellten Ausgangsstrom entspricht,
**dadurch kennzeichnet, dass**
das Eingangssignal an einem ersten Teil-Treiberschaltkreis (TT1) unmittelbar und an dem zweiten bis zu dem n-ten Teil-Treiberschaltkreis (TT2-TT7) mit Hilfe von einem, zwei,... bzw. (n-1) Verzögerungselementen (DP1-DP6, DN1-DN6) mit einer Verzögerung von 1 xΔt, 2xΔt,... bis (n-1) xΔt verzögert angelegt ist,
wobei die Teil-Treiberschaltkreise (TT1-TT7) differenzielle Treiberschaltkreise mit einem direkten Eingang (22) für das direkte Eingangssignal (INP) und einem komplementären Eingang (24) für das komplementäre Eingangssignal (INN) und mit einem direkten Ausgang (12) zum Bereitstellen eines Ausgangsstroms, der dem direkten Eingangssignal (INP) entspricht, und einem komplementären Ausgang (16) für das Bereitstellen des komplementären Ausgangsstroms sind,
wobei sowohl das direkte Eingangssignal (INP) als auch das komplementäre Eingangssignal (INN) an die Eingänge (22, 24) der Teil-Treiberschaltkreise (TT1-TT7) über die Verzögerungselemente (DP1-DP6, DN1-DN6) angelegt sind,
wobei jeder Teil-Treiberschaltkreis (TT1-TT7) einen Stromzweig (P3, P2) von einer Stromquelle, die den Referenzstrom an den direkten Ausgang (12) liefert, und einen Stromzweig (P3, P1) von dieser Stromquelle an den komplementären Ausgang (16) umfasst, wobei jeder Stromzweig ein Schaltelement (P1, P2) aufweist, von denen eines durch das direkte Eingangssignal (INP) und das andere durch das komplementäre Eingangssignal (INN) so gesteuert ist, dass jederzeit mindestens eines der beiden Schaltelemente (P1, P2) in seinem eingeschalteten Zustand ist, und
wobei die Schaltelemente (P1, P2) durch MOS-Feldeffekttran-sistoren gebildet sind, wobei jeder der Teil-Treiberschaltkreise (TT1-TT7) einen ersten Verzögerungsschaltkreis (D1), der eine Spannung zum Steuern des MOS-Feldeffekttransistors, der dem Eingang (22) für das direkte Eingangssignal (INP) zugeordnet ist, generiert, und einen zweiten Verzögerungsschaltkreis (D2) umfasst, der eine Spannung zum Steuern des MOS-Feldeffekttransistors, der dem Eingang (24) für das komplementäre Eingangssignal (INN) zugeordnet ist, wobei diese Verzögerungsschaltkreise (D1, D2) abhängig von einem Wechsel des Datenwerts des Eingangssignals die von ihnen zum Umschalten der von ihnen gesteuerten MOS-Feldeffekttransistoren von dem ausgeschalteten Zustand in den eingeschalteten Zustand generierte Spannung an diesen MOS-Feldeffekttransistoren ohne jede Verzögerung liefern, und
wobei die von ihnen zum Umschalten der MOS-Feldeffekttransistoren von dem eingeschalteten Zustand in den ausgeschalteten Zustand generierte Spannung an diese MOS-Feldeffekttransitoren nach einer Verzögerung angelegt wird.

2. Verfahren zum Erzeugen eines anpassbaren Ausgangsstroms mit einer Schaltungsanordnung nach Anspruch 1, wobei zum Bereitstellen eines minimalen Ausgangsstroms mit dem doppelten Wert des Referenzstroms (Iref) durch das Setzsignal, der Teil-Treiberschaltkreis (TT1), der das Setzsignal unmittelbar empfängt, und der Teil-Treiberschaltkreis (TT7), der das Setzsignal mit einer Verzögerung von (n-1)xΔt empfängt, in ihren aktivierten Zustand gesetzt werden, und
wobei zum Bereitstellen von höheren Ausgangsströmen weitere Teil-Treiberschaltkreise (TT2-TT6), an die das Setzsignal nach verschiedenen Verzögerungszeiten von zwischen Δt und (n-1)xΔt angelegt wird, durch das Setzsignal in ihren aktivierten Zustand versetzt werden.

## Revendications

1. Circuit d'attaque pour la fourniture d'un courant réglable de signal de sortie à une sortie d'attaque, au moyen duquel le courant de signal de sortie correspond dans chaque cas à l'une ou l'autre valeur binaire de données d'un signal d'entrée, avec n circuits partiels d'attaque reliés en parallèle à la fois à leurs entrées et à leurs sorties, qui dans le but de fixer le courant de signal de sortie peuvent être mis dans un état soit actif soit inactif au moyen d'un signal d'activation, et qui dans leur état actif fournissent dans chaque cas à leurs sorties un courant partiel de signal correspondant à un courant constant de référence en fonction de la valeur de données de la valeur d'entrée, de sorte que la somme des courant partiels de signal corresponde au courant fixé de signal de sortie, **caractérisé en ce que**
le signal d'entrée est appliqué à un premier circuit partiel (TT1) d'attaque directement, et à un deuxième jusqu'à un n-ième circuit partiel (TT2-TT7) d'attaque retardé par l'intermédiaire respectivement de 1, 2, ... ou n-1 éléments (DP1-DP6, DN1-DN6) de retard avec un retard respectif de 1 x Δt, 2 x Δt, jusqu'à n(-1) x Δt,
les circuits partiels (TT1-TT7) d'attaque sont des circuits différentiels d'attaque ayant une entrée directe (22) pour un signal direct (INP) d'entrée et une entrée complémentaire (24) pour un signal complémentaire (INN) d'entrée, ainsi qu'une sortie directe (12) pour la fourniture d'un courant de signal de sortie correspondant au signal direct (INP) d'entrée et une sortie complémentaire (16) pour la fourniture d'un courant de signal complémentaire de sortie, et qu'à la fois le signal direct (INP) d'entrée et le signal complémentaire (INN) d'entrée sont appliqués aux entrées (22, 24) des circuits partiels (TT1-TT7) d'attaque par l'intermédiaire des éléments (DP1-DP6, DN1-DN6) de retard,
chaque circuit partiel (TT1-TT7) d'attaque comprend un branchement (P3, P2) de courant provenant d'une source de courant délivrant le courant de référence à la sortie directe (12), et un branchement (P3, P1) de courant provenant de cette source de courant à destination de la sortie complémentaire (16), dans lequel chaque branchement de courant comprend un dispositif (P1, P2) de commutation dont l'un est commandé par le signal direct (INP) d'entrée et l'autre par le signal complémentaire (INN) d'entrée de manière qu'au moins l'un des deux dispositifs (P1, P2) de commutation soit dans son état passant à tout instant donné, et
lesdispositifs (P1, P2) de commutation sont constitués de transistors MOS à effet de champ, dans lequel chacun des circuits partiels (TT1-TT7) d'attaque comprend un premier circuit (D1) de retard qui crée une tension pour la commande du transistor MOS à effet de champ affecté à l'entrée'(22) pour le signal direct (INP) d'entrée, et un deuxième circuit (D2) de retard qui crée une tension pour la commande du transistor MOS à effet de champ affecté à l'entrée (24) pour le signal complémentaire (INN) d'entrée, afin que ces circuits (D1, D2) de retard, à la suite d'une changement de la valeur de données du signal d'entrée, fournissent la tension créée par eux pour la commutation de ces transistors MOS à effet de champ commandés par eux de l'état bloqué à l'état passant, à ces transistors MOS à effet de champ sans être soumis à aucun retard,
et la tension créée par eux pour commutation de ces transistors MOS à effet de champ de l'état passant à l'état bloqué est appliquée à ces transistors MOS à effet de champ après un retard.

2. Procédure pour la génération d'un courant réglable de signal de sortie en utilisant une configuration de circuit selon la revendication 1, dans laquelle, pour fournir un courant minimal de signal de sortie du double de la valeur du courant (Iref) de référence par le signal d'activation, le circuit partiel (TT1) d'attaque recevant directement le signal d'activation; et le circuit partiel (TT7) d'attaque recevant le signal d'activation avec un retard de n(-1) x Δt sont mis dans leur état actif et dans le but de délivrer un courant de signal de sortie plus élevé, des circuits d'attaque partiels supplémentaires (TT2 ― TT6) sont placés dans une position active par le signal d'activation, auxquels le signal d'activation est appliqué après des intervalles différents de retard de Δt à n(-1) x Δt.
